# EUROPÄISCHE PATENTSCHRIFT

(11) **EP 1 078 458 B1**
(45) Veröffentlichungstag und Bekanntmachung des Hinweises auf die Patenterteilung: **10.12.2003**
(21) Anmeldenummer: 99922137.7
(22) Anmeldetag: 27.04.1999
(51) Int. Cl.: H03K 5/15

(54) **ZEITGABEVORRICHTUNG UND ZEITGABEVERFAHREN**
TIMING DEVICE AND METHOD
DISPOSITIF ET PROCEDE DE SYNCHRONISATION

(30) Priorität: 11.05.1998 EP 98108535
(43) Veröffentlichungstag der Anmeldung: 28.02.2001
(73) Patentinhaber: Infineon Technologies AG, 81669 München (DE)
(72) Erfinder: KELLER, Hans-Georg, D-81737 München (DE); SELLAR, David, D-81675 München (DE)
(74) Vertreter: Graf Lambsdorff, Matthias, Dr.
(86) Internationale Anmeldenummer: EP9902857
(87) Internationale Veröffentlichungsnummer: WO99059247

(56) Entgegenhaltungen:
- EP-A- 0 401 763
- EP-A- 0 678 992
- WO-A-96/16522
- WO-A-97/47097
- GB-A- 2 245 727
- US-A- 4 553 100
- US-A- 4 719 593
- US-A- 5 461 310
- US-A- 5 670 964
- US-A- 5 673 275

## Beschreibung

Die Erfindung betrifft eine Zeitgabevorrichtung und ein Zeitgabeverfahren, sowie eine Verwendung der Zeitgabevorrichtung.

Aus der US 5,594,737 ist eine Anordnung zum Steuern einer Sende/Empfangs-Vorrichtung einer Basisstation und/oder mobiler Einheiten eines Mobilfunksystems bekannt geworden. Dabei ist ein Prozessor vorgesehen, der mit einem Zeitgeber bzw. Zähler ausgestattet ist und mit dessen Hilfe andere Elemente des Systems, insbesondere die Sende/Empfangs-Vorrichtung steuert. Eine derartige Steuerung ist bei Mobilfunksystemen auf der Basis von TDMA erforderlich, weil beispielsweise die mobile Einheit abwechselnd in einem Zeitschlitz sendet und in einem anderen Zeitschlitz empfängt. Die zeitliche Abfolge und Dauer der Sende- bzw. Empfangszeiträume ist in den jeweiligen Mobilfunkstandards, beispielsweise GSM oder DECT festgelegt. Die Zeitpunkte bzw. Zeiträume können dabei in festgelegten Grenzen während der Dauer einer Kommunikation variieren.

Der Steuerprozessor von US 5,594,737 erzeugt unter anderem Zeitgabesignale für die anderen Schaltungsteile, damit diese zu den erforderlichen Zeitpunkten aktiviert bzw. deaktiviert werden. Ein typisches Beispiel hierfür ist der Antennenschalter, der die Antenne je nach Erfordernis mit dem Empfangsweg bzw. mit dem Sendeweg verbindet. Während US 5,594,737 eine Anordnung zeigt, die insbesondere bei dem Mobilfunkstandard DECT eingesetzt werden kann, zeigt WO 98/13949 eine bezüglich dieser Erfindung ähnliche Struktur, die insbesondere beim Mobilfunkstandard GSM eingesetzt werden kann. Der dort gezeigte Logik- und Steuerungsblock LSB übernimmt unter anderem das bedarfsgerechte Ein- und Ausschalten von Schaltungsteilen eines TDMA-Empfangsgerätes.

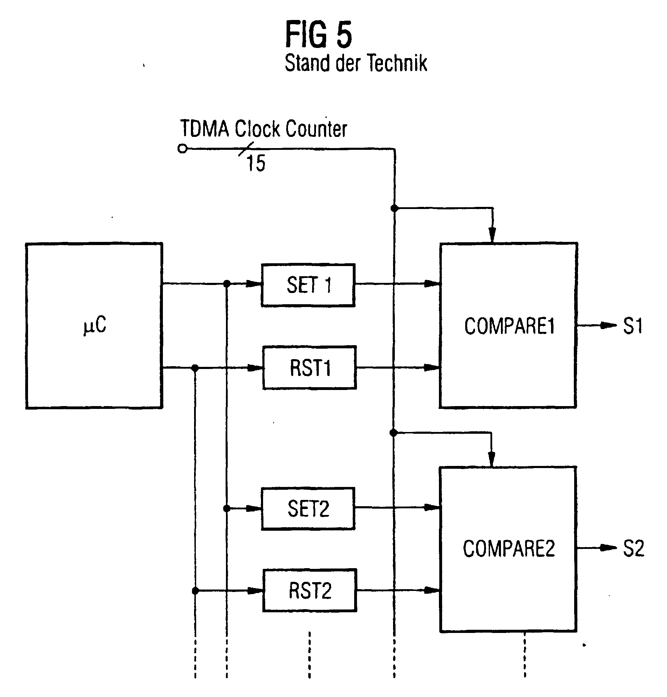

Figur 5 zeigt die wesentlichen Elemente der Zeitgabevorrichtung, die in einem Baustein der Anmelderin zum Einsatz kommt, der unter der Bezeichnung PMB 2800 erhältlich ist. Nach Figur 5 wird der momentane Zählerstand eines 15 Bit breiten TDMA Clock Counter einer Vielzahl von Vergleichereinheiten COMPARE 1, COMPARE 2, ... zugeführt. Der TDMA Clock Counter wird dabei von einem Takt mit der Frequenz 2,166 MHz angesteuert. Jede Vergleichereinheit vergleicht den momentanen Zählerstand des TDMA Clock Counter mit einem Setzwert, z. B. SET 1, und einem Rücksetzwert, z. B. RST 1. Wenn der momentane Zählerstand des TDMA Clock Counter mit dem Setzwert übereinstimmt, setzt die Vergleichereinheit das ihr zugehörige Ausgangssignal, z. B. S1. Das Ausgangssignal bleibt so lange gesetzt, bis der TDMA Clock Counter den Rücksetzwert erreicht, d. h. der momentane Zählerstand stimmt mit dem Rücksetzwert überein, woraufhin die Vergleichereinheit das Ausgangssignal rücksetzt. Der Setzwert und der Rücksetzwert für jedes der Ausgangssignale S1, S2, ... ist jeweils in einem Register SET 1 bzw. RST 1 abgelegt, dessen Inhalt von einer Steuereinrichtung µC festgelegt wird.

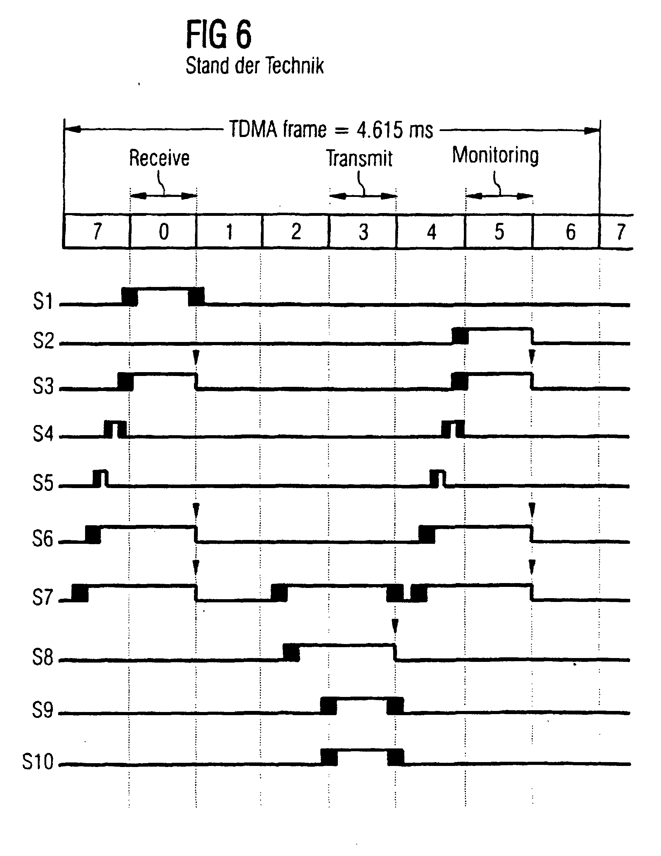

Mit Hilfe einer Schaltung gemäß Figur 5 ist es beispielsweise möglich Signalverläufe entsprechend Figur 6 zu erzeugen. Beispielsweise ist das Signal S1 im Bereich des Empfangsschlitzes 0 aktiv, wohingegen die Ausgangssignale S9 und S10 im Bereich des Sendeschlitzes 3 aktiv sind. Andere Signale dienen der Ansteuerung von Schaltungsteilen, die das Senden bzw. Empfangen oder der Überwachung eines Monitorkanals im'Zeitschlitz 5 betreffen. Die zeitliche Lage der TDMA-Rahmen und die Zuordnung von Sende-, Empfangs- und Überwachungszeitschlitzen wird von der Basisstation des Mobilfunksystems festgelegt. Die mobile Einheit, in der der Baustein PMB 2800 vorzugsweise eingesetzt wird, hat die zum Senden, Empfangen oder Überwachen erforderlichen Zeitgaben an die Vorgaben der Basisstation und an die momentane Situation des Funkübertragungsweges anzupassen. Dabei müssen die für das Mobilteil vorgesehenen Zeitgaben gegenüber dem TDMA-Rahmen der Basisstation verändert werden, je nachdem ob sich die mobile Einheit von der Basisstation weg bewegt oder zu dieser hin bewegt, um entsprechend verkürzte oder verlängerte Funkübertragungslaufzeiten zu kompensieren. Dies ist in Figur 6 bei den einzelnen Signalen durch entsprechende schwarze Blöcke dargestellt, die das erlaubte Zeitfenster für einen Signalwechsel darstellen. In ähnlicher Weise sind die Zeitgaben an die Erfordernisse einer jeweiligen Schaltungsumgebung (im Rahmen eines Chipsatzes) anzupassen. Die in Figur 5 dargestellte Steuereinheit µC kann durch entsprechende Programmierung der Setz- bzw. Rücksetzregister die erforderlichen Signalwechselzeitpunkte entsprechend einstellen.

Ein Nachteil der bisherigen Konfiguration besteht darin, daß für jedes der Signale S1, S2, ... S10 von Figur 6 genau eine Vergleichereinheit COMPARE 1, COMPARE 2, ... vorgesehen werden muß, die an ihrem Ausgang das jeweilige Signal erzeugt. Falls der Baustein, der diese Schaltung enthält, in einer Umgebung eingesetzt wird, die eine höhere Zahl von Zeitgabesignalisierungen erfordert, kann der Baustein diese nicht zur Verfügung stellen. Darüber hinaus sind die Zeitgaben verschiedener Signale teilweise von einander abhängig. Dies läßt sich entweder durch eine feste Verdrahtung zwischen den Setz- bzw. Rücksetzeingängen an den Vergleichereinheiten berücksichtigen, oder die Steuereinheit µC programmiert alternativ die Setz- bzw. Rücksetzregister in entsprechender Weise. Eine feste Verdrahtung leidet jedoch unter einer mangelnden Flexibilität der Signalerzeugung. Die alternative Vorgehensweise nimmt Rechenleistung der Steuereinheit µC in Anspruch, die so wenig wie möglich mit der Neuprogrammierung der Setz- bzw. Rücksetzregister belastet werden sollte, da sie eine Vielzahl anderer Aufgaben in ihrer Schaltungsumgebung erledigen muß. Neueste Anforderungen der erwähnten Mobilfunkstandards, insbesondere von GSM (siehe zum Beispiel ETSI prETS 300 908, Nov. 96 für mulitslot applications), erfordern eine weit über das bisherige Maß hinaus gehende Anzahl von Zeitgabesignalen, die untereinander in flexibler Weise einstellbar sein sollen.

Die Druckschrift WO 97/47097 beschreibt eine Zeitgabevorrichtung für ein digitales Kommunikationssystem zur Erzeugung einer Vielzahl von Signalen bzw. Signaländerungen durch einen Signalgenerator. Zu diesem Zweck weist die Zeitgabevorrichtung einen RAM-Speicher auf, in welchem eine sogenannte Ereignisliste gespeichert ist, die eine Vielzahl von Zeitgabeereignissen enthält, die periodisch zu bestimmten Zeiten abgearbeitet werden müssen. Jedem Zeitgabeereignis ist ein Zeitgabewert, der einem vorbestimmten Zeitpunkt entspricht, und ein Ereigniscode zugeordnet. Die Solldaten der Ereignisliste werden in Vergleichern mit Zeitdaten aus Zählern verglichen und bei Übereinstimmung wird der entsprechende Ereigniscode an einen Signalgenerator weitergegeben, welcher dann die dem Ereigniscode entsprechende Ereignisänderung erzeugt.

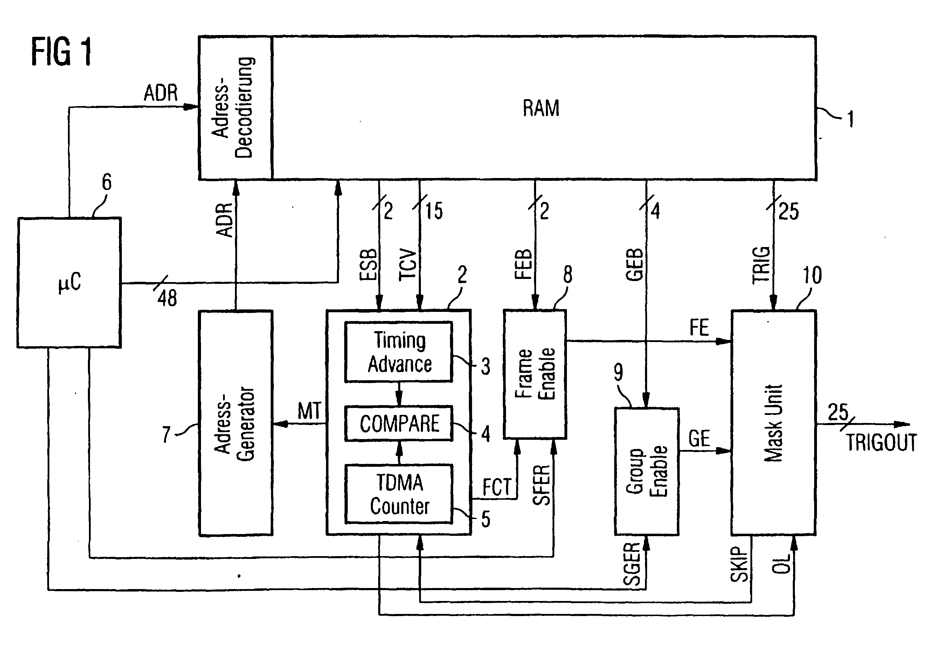

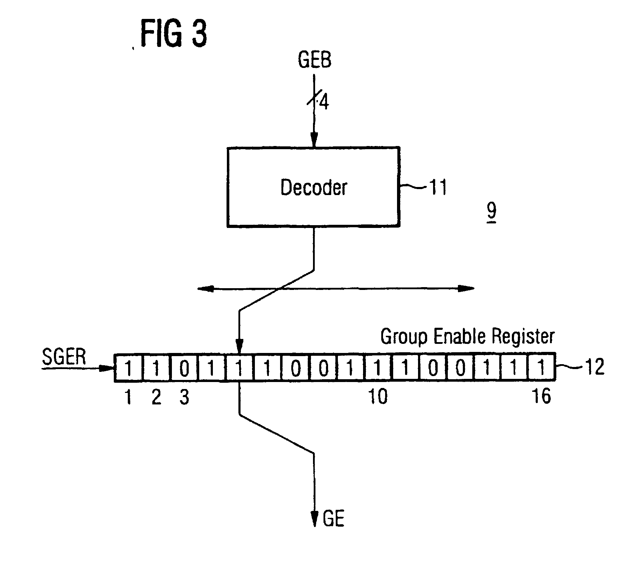

Die Druckschrift US 4,719,593 A betrifft ebenfalls eine Zeitgabevorrichtung für eine Zustandsmaschinensteuerung. Bei dieser Zeitgabevorrichtung werden nicht Zustandscodes gespeichert, die abgearbeitet bzw. decodiert müssen, sondern es werden gemäß Fig. 3 digitale Ausgabewerte direkt in einem zugeordneten Speicher gespeichert und gemäß Fig. 1 bei Aufruf einem Ausgangsbus zugeführt, damit sie anschließend unmittelbar in entsprechende Signaländerungen umgesetzt werden können.

Das der Erfindung zugrundeliegende technische Problem besteht darin, eine Zeitgabevorrichtung und ein Zeitgabeverfahren anzugeben, die bzw. das in flexibler Weise eine Vielzahl von Zeitgabesignalen erzeugen kann.

Dieses Problem wird gelöst durch eine Vorrichtung mit den Merkmalen von Patentanspruch 1 und durch ein Verfahren mit den Merkmalen von Patentanspruch 10. Eine Verwendung der Vorrichtung ist in Patentanspruch 11 angegeben.

Die erfindungsgemässe Zeitgabevorrichtung dient dem Erzeugen und Ausgeben einer Vielzahl von Signalflanken durch Änderung von Signalzuständen zu vorbestimmbaren Zeitpunkten. Sie weist einen zyklisch adressierten Speicher auf, in dem eine Vielzahl von Zeitgabeereignissen gespeichert ist. Jedem Zeitgabeereignis ist ein Zeitgabewert und eine Vielzahl von Signalzuständen zugeordnet. Der Zeitgabewert entspricht dabei einem vorbestimmten Zeitpunkt. Die Zeitgabevorrichtung weist ferner einen Vergleicher auf, der den momentanen Zählerstand eines Zählers mit dem momentan aus dem Speicher gelesenen Zeitgabewert eines Zeitgabeereignisses vergleicht und bei Übereinstimmung das nächste Zeitgabeereignis aus dem Speicher liest. Die Zeitgabevorrichtung weist darüber hinaus eine Ausgabeeinrichtung auf, die die vorgegebenen Signalzustände ausgibt. Durch entsprechende Belegung des Speichers ist es auf diese Weise möglich, flexibel eine Vielzahl von Zeitgabesignalen zu erzeugen. Die Anzahl der Zeitereignisse und die Anzahl von Zeitgabesignalen pro Zeitereignis kann dadurch voll flexibel gestaltet werden und ist nur durch den verfügbaren Speicherplatz begrenzt. Darüber hinaus ist es ebenfalls mühelos möglich, für ein Zeitgabesignal mehr als einen Setz- und Rücksetzvorgang pro Zählzyklus zu erhalten, weil dies ebenfalls durch einfache Belegung des Speichers möglich ist. Insbesondere können gleichzeitige Zeitgaben auf verschiedenen Zeitgabesignalen durch entsprechende Belegung des Speichers erzielt werden und brauchen nicht, wie bisher, durch eine fest verdrahtete logische Verknüpfung zwischen den Zeitgabesignalen erzeugt zu werden.

Die erfindungsgemässe Zeitgabe-vorrichtung weist eine Zeitversatzeinrichtung auf, die dem Vergleicher vorgeschaltet ist. Die Zeitversatzeinrichtung addiert zu dem aus dem Speicher ausgelesenen Zeitgabewert einen Zeitversatzwert. Das Ergebnis der Addition wird dann dem Vergleicher zugeführt. Dazu weist die Zeitversatzeinrichtung vorzugsweise ein Register auf, in dem der Zeitversatzwert gespeichert ist. Der Zeitversatzwert kann sowohl positive als auch negative Werte annehmen. Solange ein von null verschiedener Wert in dem Register der Zeitversatzeinrichtung gespeichert ist, werden die daraus erzeugten Zeitgaben gegenüber den in den Speicher programmierten Zeitgabewerten vorlaufen bzw. nachlaufen, je nachdem ob ein positiver oder negativer Zeitversatzwert gespeichert wurde. Dies ist besonders dann vorteilhaft, wenn eine größere Zahl von Zeitereignissen in ihren Zeitgabewerten um einen bestimmten Wert versetzt werden sollen. Dies ist beispielsweise dann der Fall, wenn sich ein Mobilteil von der Basisstation weg bewegt und damit der Sendezeitpunkt des Mobilteils geringfügig vorverlegt werden muß, damit das bei der Basisstation ankommende Sendesignal des Mobilteils präzise in den Empfangsschlitz der Basisstation fällt. In diesem Fall müssen alle Zeitgabewerte, die zum Sendezeitschlitz gehören, entsprechend vorverlegt werden. Dies ist durch entsprechende Programmierung des Registers in der Zeitversatzeinrichtung problemlos möglich.

In einem weiteren bevorzugten Ausführungsbeispiel weist jedes Zeitgabeereignis einen Gruppencode auf. Damit ist es möglich, jeden Speichereintrag einer bestimmten Gruppe zuzuordnen. Mit einer entsprechenden Auswertelogik können Gruppen von Zeitgaben innerhalb der Vielzahl von Zeitgabesignalen nach Bedarf ein- und ausgeblendet werden. Das Ein- bzw. Ausblenden von Zeitgaben erfolgt vorzugsweise durch Programmierung eines Gruppenfreigaberegisters.

In einer besonders bevorzugten Ausführungsform weist jedes Zeitgabeereignis einen Rahmencode auf. Dieser ist besonders vorteilhaft im Mobilfunkssystem nach dem Standard GSM, bei dem bestimmte Rahmensequenzen mit einer Periodendauer von 26 TDMA-Rahmen vorgesehen sind. Mit dem Rahmencode ist es möglich, eine Auswahl von Zeitgaben innerhalb der Vielzahl von Zeitgabesignalen abhängig vom gerade durchlaufenen Rahmen innerhalb des Rahmenzyklus mit 26 TDMA-Rahmen ein- bzw. auszublenden. Die Programmierung erfolgt vorzugsweise über ein Rahmenfreigaberegister, dessen Inhalt logisch mit dem Rahmencode eines Speichereintrags verknüpft wird.

Ein erfindungsgemässes Verfahren zum Erzeugen einer Vielzahl von Signalflanken zu vorbestimmbaren Zeitpunkten, weist zunächst den Schritt des Speicherns einer Vielzahl von Zeitgabeereignissen in einer vorgegebenen Reihenfolge jeweils mit Zeitgabewerten und einer Vielzahl von Signalzuständen auf. Es folgt das Auslesen eines Zeitgabeereignisses aus dem Speicher und das Vergleichen des im Zeitgabeereignis enthaltenen Zeitgabewertes mit dem momentanen Zählerstand eines Zählers. Wenn der gerade gelesene Zeitgabewert mit dem momentanen Zählerstand des Zählers übereinstimmt, wird das nächste Zeitgabeereignis aus dem Speicher gelesen. Dabei wird die Vielzahl von Signalzuständen eines Zeitgabeereignisses ausgegeben. Signalflanken entstehen durch Wechsel eines Signalzustandes von einem ersten Zustand zu einem zweiten Zustand oder umgekehrt.

Vor dem Schritt des Vergleichens wird ein Schritt des Addierens eines Zeitversatzwertes zum gerade ausgelesenen Zeitgabewert durchgeführt.

Eine derartige Vorrichtung oder ein derartiges Verfahren kann vorteilhafterweise in jedem TDMA-Übertragungssystem eingesetzt werden, bei dem Zeitgaben flexibel und präzise gesteuert werden müssen. Dies betrifft insbesondere Mobilfunksysteme, bei denen wiederkehrende Zeitgaben erzeugt werden müssen (z. B. UMTS, Universal Mobile Telephone). Besonders vorteilhaft läßt sich die Erfindung in Mobilfunksystemen auf der Basis von TDMA einsetzen (insbesondere DECT und GSM). Besondere Vorteile ergeben sich dabei beim Einsatz der Erfindung in einem Mobilteil.

Weiter Vorteile, Merkmale und Anwendungsmöglichkeiten der Erfindung ergeben sich aus der nachfolgenden Beschreibung von Ausführungsbeispielen in Verbindung mit der Zeichnung. In der Zeichnung zeigen:
- Figur 1: ein Ausführungsbeispiel einer Zeitgabevorrichtung nach der Erfindung;
- Figur 2a: beispielhaft einen Ausschnitt aus dem Inhalt des Speichers von Figur 1;
- Figur 2b: die zu Figur 2a gehörigen Signalverläufe von Zeitgabesignalen;
- Figur 3: ein Ausführungsbeispiel einer Gruppenfreigabeeinrichtung nach der Erfindung;
- Figur 4: ein Ausführungsbeispiel einer Rahmenfreigabeeinrichtung nach der Erfindung;
- Figur 5: die prinzipielle Struktur einer Zeitgabevorrichtung nach dem Stand der Technik; und
- Figur 6: Zeitgabesignale, wie sie mit einer Struktur nach Figur 5 erzeugt werden können.

Figur 1 zeigt ein bevorzugtes Ausführungsbeispiel einer Zeitgabevorrichtung der Erfindung. Es zeigt einen Speicher 1 in Form eines RAM (Random Access Memory), der über eine Adreß-Decodierung verfügt. Speicher 1 entspricht in seinem Aufbau einem RAM, wie er handelsüblich erhältlich ist. Die Zeitgabevorrichtung weist eine Vergleichereinheit 2 auf, die über Datenbusleitungen TCV (Timing Compare Value) und ESB (Entry Select Bit) mit einem Teil der Datenausgangsanschlüsse des Speichers 1 verbunden ist. Der Datenbus TCV hat eine Bitbreite von 15 Bit, und der Datenbus ESB hat eine Bitbreite von 2 Bit. Die Vergleichereinheit 2 ist über eine Signalleitung MT (Match Timer) mit einem Adreßgenerator 7 verbunden, um diesen aufzufordern, eine neue Adresse zu erzeugen. Der Adreßgenerator 7 seinerseits ist über die Adreßbusleitung ADR mit den Adreßeingängen des Speichers 1 verbunden.

Die Vergleichereinheit 2 weist einen Zähler 5, eine Vergleichslogik 4 und eine Zeitversatzeinrichtung 3 auf. Der Zähler 5 (TDMA-Counter) ist ein mod1000_{D}-Zähler, der mit einer Frequenz von 2,166 MHz getaktet ist. D. h., nach 10000 Taktimpulsen wird der Zähler rückgesetzt, um erneut auf den Dezimalwert 10000 zu zählen. Die Umlaufzeit des Zählers entspricht bei einer Taktfrequenz von 2,166 MHz genau der Rahmendauer von 4,615 ms eines TDMA-Rahmens mit 8 Zeitschlitzen eines GSM-Mobilfunksystems. Die binäre Darstellung des Zählerstands des Zählers 5 wird an die Vergleicherlogik 4 übergeben. Die Vergleicherlogik 4 vergleicht diesen Zählerstand mit dem Ausgabewert der Zeitversatzeinrichtung 3. Wenn der binäre Zählerstand des Zählers 5 und der Ausgabewert der Zeitversatzeinheit 3 übereinstimmen, gibt die Vergleicherlogik 4 ein Signal an den Adreßgenerator 7 aus, der daraufhin eine neue Adresse in dem Speicher 1 adressiert.

Die Zeitversatzeinrichtung 3 weist ein Register auf, in dem ein Zeitversatzwert gespeichert ist. Der Inhalt des Registers ist an einen Addierer angelegt, der den Zeitversatzwert zu dem binären Wert der Busleitung TCV addiert. Wenn demnach ein Zeitversatzwert von null in dem Register gespeichert ist, wird der binäre Wert der Busleitung TCV zur Vergleichslogik 4 durchgereicht. Das Zeitversatzregister wird über den Datenbus TCV programmiert, wenn dies auf dem Datenbus ESB signalisiert wird. In einem alternativen Ausführungsbeispiel könnte das Zeitversatzregister in der Zeitversatzeinrichtung 3 durch eine besondere Steuereinrichtung programmiert werden.

Die Zeitgabesignale sind an Datenbusleitungen TRIG mit einer Busbreite von 25 Bit am Ausgang des Speichers 1 abgreifbar. Sie werden über eine Ausblendeinrichtung 10 an einem Datenbus TRIGOUT mit einer Busbreite von 25 Bit ausgegeben. Die Vergleichereinheit 2 zeigt der Ausblendeinheit mittels eines Signals OL (Output Latch) an, die gerade anliegenden Datenbussignale TRIG am Ausgang TRIGOUT auszugeben.

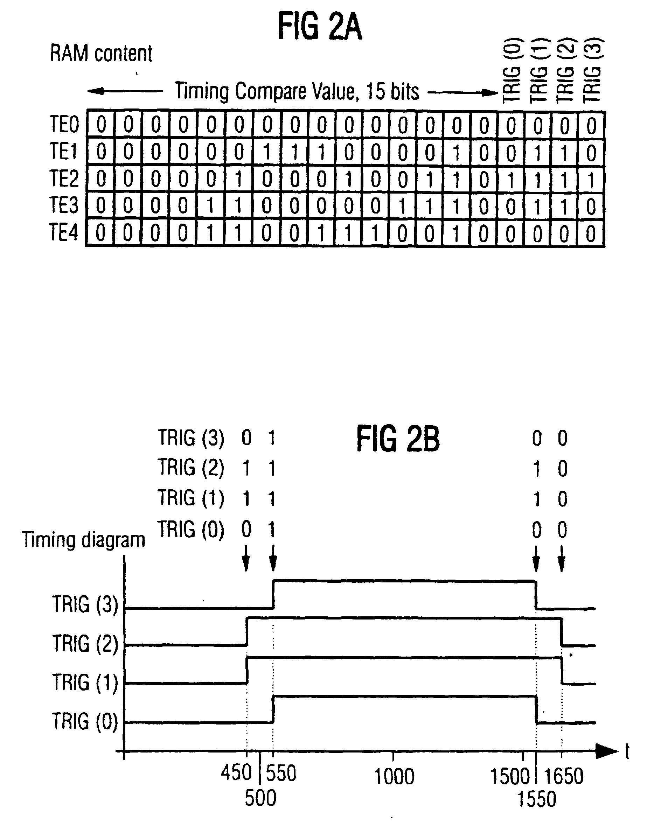

Die grundsätzliche Funktionsweise der Zeitgabevorrichtung wird anhand eines beispielhaften Ausschnitts einer Speicherbelegung nach Figur 2a ersichtlich. Figur 2a zeigt einen Ausschnitt aus dem Speicher 1 mit 5 Einträgen, die mit TE0, TE1, .... TE4 bezeichnet sind und auf diese Weise im Speicher adressierbar sind. Zu jedem Eintrag in dem Speicher 1 gehören ein Zeitgabewert mit einer Breite von 15 Bit, der über den Datenbus TCV auslesbar ist, und eine Vielzahl von Signalzuständen, die an dem Datenbus TRIG abgreifbar sind.

Das Zeitdiagramm von Figur 2b zeigt den Verlauf der Signalzustände, wie sie in Figur 2a programmiert sind und von der Vorrichtung der Erfindung ausgegeben werden. Im folgenden wird ein Zeitversatzwert von null angenommen. Zum Zeitpunkt 0_{D} sind die Signalzustände TRIG (0) bis TRIG (3) auf dem Signalpegel 0. Die Signalzustände TRIG (0) bis TRIG (3) werden mittels einer Zwischenspeichereinrichtung auf diesem Wert gehalten, während im Speicher das nächste Zeitgabeereignis TE1 adressiert wird. Demnach wird nun der momentane Zählerstand mit dem Zeitgabewert von TE1 verglichen. Wenn, wie gezeigt in den Figuren 2a und 2b, der momentane Zählerstand den Wert 450_{D} erreicht, werden die zum Zeitereignis TE1 gehörigen Signalzustände an den Ausgang durchgeschaltet und gehalten. Im gezeigten Beispiel wechseln die Signalzustände TRIG (1) und TRIG (2) jeweils von 0 auf 1, während die Signalzustände TRIG (0) und TRIG (3) auf 0 bleiben. Mit dem Übereinstimmen des Zählerstandes mit dem Zeitgabewert TE1 wird auch die Adressierung des Speichers um eine Stelle inkrementiert auf das Zeitereignis TE2, während die Signalzustände des Zeitereignisses TE1 am Ausgang gehalten werden. Bis zum Erreichen des Zeitgabewertes von TE2 bleiben die Signalzustände TRIG (0) bis TRIG (3) unverändert. Sobald der Zählerstand den Wert 550_{D} erreicht, werden die Signalzustände des Zeitereignisses TE2 an den Ausgang durchgeschaltet. Zu diesem Zeitpunkt wechseln demnach auch die Signalzustände TRIG (0) und TRIG (3) von 0 auf 1 und werden dort gehalten. Gleichzeitig schaltet die Vorrichtung auf das nächste Zeitereignis TE3. Die im Speicher abgelegten Zeitereignisse werden auf diese Weise nacheinander abgearbeitet. Bei Erreichen des letzten Zeitereignisses wird auf das erste in dem Speicher gespeicherte Zeitereignis geschaltet, so daß der Speicher zyklisch ausgelesen wird.

Die Programmierung des Speichers 1 erfolgt über eine Steuereinrichtung 6, die über eine Adreßleitung ADR und über eine Datenbusleitung mit dem Speicher 1 verbunden ist. Im gezeigten Ausführungsbeispiel weist der Datenbus eine Gesamtbreite von 48 Bit auf. Der Datenbus enthält dabei unter anderem den Datenbus TCV mit einer Breite von 15 Bit und die auszugebenden Signalzustände TRIG mit einer Breite von 25 Bit.

Im gezeigten Ausführungsbeispiel weist ein Eintrag in dem Speicher 1 die Eintragkennung ESB mit einer Breite von 2 Bit auf. Die Kennung ESB zeigt an, ob ein Speichereintrag ein Zeitereignis bestehend aus einem Zeitgabewert TCV und Signalzuständen TRIG darstellt, oder ob in dem betreffenden Eintrag ein Zeitversatzwert gespeichert ist. Wenn die Kennung ESB anzeigt, daß in dem gerade adressierten Eintrag ein Zeitversatzwert gespeichert ist, dann werden die Ausgangsbits TCV nicht als Zeitgabewert behandelt, sondern der dort enthaltene Wert wird in dem Zeitversatzregister abgelegt. Mit Hilfe der Kennung ESB kann damit zwischen Speichereintragen als einem Zeitereignis (wie in Figur 2a) und Speichereinträgen zum Setzen des Zeitversatzregisters unterschieden werden. Durch gezielte Programmierung des Speichers 1 können somit im Verlaufe eines Zählzyklus unterschiedliche Zeitversatzwerte für eine große Zahl von Zeitereignissen vorgegeben werden.

Zu jedem Eintrag in dem Speicher 1, d. h. sowohl Zeitereigniseinträge als auch Zeitversatzeinträge, gehört ein 4 Bit breiter Gruppencode GEB (Groupe Enable Bit) und ein 2 Bit breiter Rahmencode FEB (Frame Enable Bit), die an ansprechenden Ausgangsanschlüssen des Speichers 1 abgreifbar sind. Der Gruppencode GEB wird einer Gruppenfreigabeeinrichtung 9 zugeführt, und der Rahmencode wird einer Rahmenfreigabeeinrichtung 8 zugeführt. Die Gruppenfreigabeeinrichtung 9 vergleicht den Gruppencode mit einem Gruppenfreigaberegister und erzeugt aus dem Vergleichsergebnis ein Gruppenfreigabesignal GE (Group Enable), das der Ausblendeinrichtung 10 zugeführt wird. Ebenso erzeugt die Rahmenfreigabeeinrichtung 8 aus dem Rahmencode FEB aus dem Inhalt eines Rahmenfreigaberegisters und aus einem Rahmentaktsignal FCT (Frame Count) ein Rahmenfreigabesignal FE (Frame Enable), das an die Ausblendeinrichtung 10 geliefert wird.

Figur 3 zeigt die prinzipielle Funktionsweise der Gruppenfreigabeeinrichtung 9. Die Gruppenfreigabeeinrichtung 9 weist einen Decodierer 11 zum Decodieren des Gruppencodes und ein Gruppenfreigaberegister 12 auf. Das Gruppenfreigaberegister 12 wird durch ein Signal SGR (Set Group Enable Register) von der Steuereinrichtung 9 programmiert. Das Gruppenfreigaberegister 12 weist, wie dargestellt in Figur 3, eine Breite von 16 Bit auf. Dies entspricht der Anzahl verfügbarer Gruppencodes, die mit 4 Bit im Speicher 1 codiert sind. Der Decodierer 11 decodiert den Gruppencode eines Speichereintrags und zeigt damit auf ein bestimmtes Bit im Gruppenfreigaberegister 12. Der Wert dieses Bits wird als Gruppenfreigabesignal GE an die Ausblendeinrichtung 10 ausgegeben. Abhängig vom Wert des gerade angewählten Bits wird der Speichereintrag von der Verarbeitung ausgeblendet oder durchgeführt.

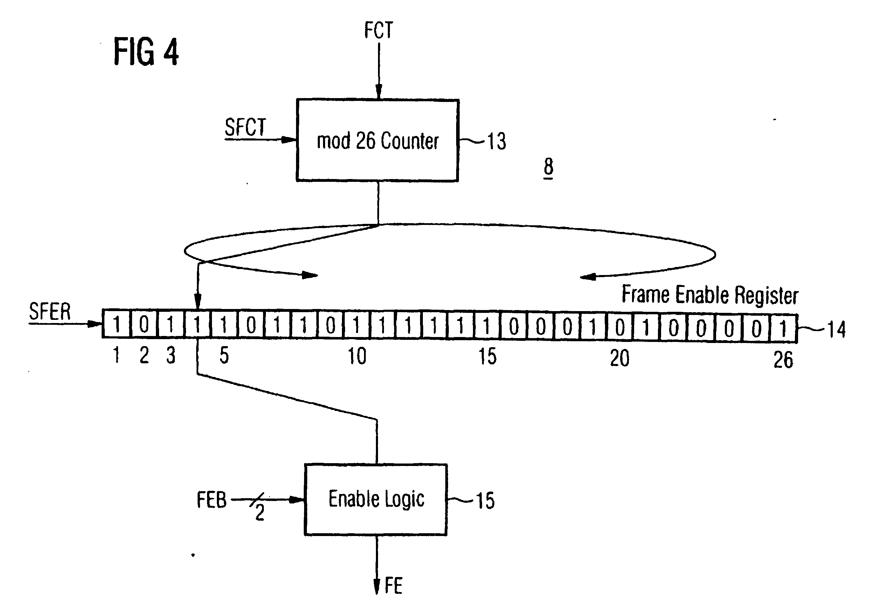

Figur 4 zeigt ein Ausführungsbeispiel der Rahmenfreigabelogik 8. Die Rahmenfreigabelogik 8 weist einen Zähler 13 auf, der mit dem Rahmentakt FCT getaktet ist. Der Rahmentakt FCT entspricht dem Rücksetzsignal des TDMA-Zählers 5 in der Vergleichereinheit 2. Der Zähler 13 ist ein mod26-Zähler, d. h., der Zähler wird nach 26 Zählimpulsen rückgesetzt. Der Zähler kann über ein Signal FCT auf einen Anfangswert gesetzt werden. Die Rahmenfreigabelogik weist ein Rahmenfreigaberegister 14 auf, das von der Steuereinrichtung 6 über die Leitung SFER (Set Frame Enable Register) programmiert werden kann. Das Rahmenfreigaberegister 14 weist eine Breite von 26 Bit auf. Der Wert 26 für den Zähler 13 und das Rahmenfreigaberegister 14 wurde deshalb gewählt, weil nach den Vorgaben des GSM-Standards sich bestimmte Rahmen mit jedem 26. Rahmen wiederholen müssen. Es entsteht dadurch ein Rahmenzyklus mit einer Länge von 26 Rahmen. Der momentane Wert des Zählers 13 zeigt auf ein bestimmtes Bit in dem Rahmenfreigaberegister 14. Der Inhalt dieses Bits wird in einer Freigabelogik 15 mit dem Rahmencode FEB verknüpft, um daraus das Rahmenfreigabesignal FE zu bilden. Auf diese Weise ist es möglich, besondere Rahmen in dem GSM-Rahmenzyklus mit unterschiedlichen Zeitgaben als andere Rahmen zu programmieren.

Die Ausblendeinrichtung 10 führt über einen Ausgangszwischenspeicher die Signalzustände TRIG als Ausgangssignalzustände TRIGOUT an den Ausgang. Der Ausgangszwischenspeicher wird über das Signal OL (Output Latch) von der Vergleichereinheit 2 betätigt. Der Ausgangszwischenspeicher in der Ausblendeinrichtung 10 wird jedoch nicht betätigt, wenn ein entsprechendes Gruppenfreigabesignal GE oder ein entsprechendes Rahmenfreigabesignal FE anliegt. In ähnlicher Weise signalisiert die Ausblendeinrichtung 10 der Vergleichereinheit 2 mittels eines Signals SKIP, daß sie sofort den nächsten Speichereintrag anfordern soll.

Die Zeitgabevorrichtung der Erfindung kann alle Zeitgabesignale bereitstellen, die periodisch in einem TDMA-Rahmen wiederholt auftreten und entlastet somit die Steuereinrichtung 6 davon, ständig Zeitereignisse zu erzeugen. Bei diesen Zeitgabesignalen handelt es sich sowohl um Signale innerhalb eines Bausteins (z. B. Triggersignale für einen Equalizer oder zum Auslösen von Frequenztelegramms für eine Hochfrequenz-Steuereinrichtung), als auch um externe Signale zum Steuern einer Hochfrequenzeinheit. Mittels einer anwenderprogrammierbaren Ereignistabelle kann jedes Zeitgabesignal sehr flexibel programmiert werden. Sie werden darüber hinaus synchron ausgegeben.

Der Speicher 1 der Zeitgabevorrichtung enthält die Information darüber, zu welchem Zeitpunkt innerhalb eines TDMA-Rahmens eines oder mehrere einer Vielzahl von Ausgangssignalen TRIG ihren Signalzustand ändern sollen, sowie die neuen Signalzustände aller Ausgangssignale zu diesem Zeitpunkt. Ein Zeitgabewert und die zugehörigen Ausgangssignale TRIG stellen zusammenfassend Zeitereignisse dar. Der Speicher 1 wird zyklisch adressiert. Der Vergleicher 4 vergleicht den letzten Zeitgabewert des Speichers 1 mit dem Zählerstand des Zählers 5. Wenn die Werte übereinstimmen, werden die aus dem Speicher 1 gelesenen Werte TRIG als Ausgangssignale TRIGOUT ausgegeben. Nach dieser Übereinstimmung wird die Speicheradresse durch den Adreßgenerator 7 inkrementiert, und der nächste Zeitgabewert wird mit dem Zählerstand des Zählers 5 verglichen.

Der Speicher 1 weist Zeitereigniseinträge und Zeitversatzeinträge auf. Innerhalb eines Taktzyklus des TDMA-Zählers 5 von 2,166 MHz kann die Steuereinrichtung 6 bis zu sechs Zugriffe auf den Speicher 1 durchführen, um diesen zu programmieren, ohne das Ausgeben von Zeitereignissen zu stören. Dies trifft in ähnlicher Weise auf das Zeitversatzregister, das Rahmenfreigaberegister 14 und das Gruppenfreigaberegister 12 zu.

Wenn ein neuer Zeitversatzwert aus dem Speicher 1 gelesen wird, wird dieser Wert in das Zeitversatzregister der Zeitversatzeinheit 3 geschrieben. Die Vergleichereinheit 2 fordert dann über die Leitung MT (Match Timer) den Adreßgenerator 7 auf, den nächsten Eintrag in dem Speicher 1 zu adressiern. Wenn ein Eintrag aus dem Speicher 1 gelesen wird, der aufgrund seines Rahmencodes und/oder seines Gruppencodes ein entsprechendes Rahmenfreigabesignal FE bzw. Gruppenfreigabesignal GE auslöst, so wird dieser Eintrag übersprungen (signalisiert durch SKIP), und der Adreßgenerator 7 wird veranlaßt, den nächsten Eintrag in dem Speicher 1 zu adressieren.

Mit dem Gruppencode ist es z. B. möglich, alle Zeitgaben die erforderlich sind, um einen Sende-Burst zu verarbeiten, einer Gruppe zuzuordnen. Auf die gleiche Weise können Zeitgaben zusammengefaßt werden und gemeinsam freigegeben oder gesperrt werden, mit denen Empfangs- und Überwachungs-Bursts verarbeitet werden oder bei denen Batteriemessungen durchgeführt werden.

## Patentansprüche

1. Zeitgabevorrichtung zum Erzeugen und Ausgeben einer Vielzahl von Signalflanken durch Änderung von Signalzuständen zu vorbestimmbaren Zeitpunkten, mit
- einem zyklisch adressierten Speicher (1), in dem eine Vielzahl von Zeitgabeereignissen (TE0, TE1, ...) gespeichert ist, wobei jedem Zeitgabeereignis ein Zeitgabewert (TCV), der einem vorbestimmten Zeitpunkt entspricht, zugeordnet ist,
- einem Vergleicher (4), der den momentanen Zählerstand eines Zählers (5) mit dem momentan aus dem Speicher (1) gelesenen Zeitgabewert eines Zeitgabeereignisses vergleicht und bei Übereinstimmung das nächste Zeitgabeereignis aus dem Speicher (1) liest, und
- einer Ausgabeeinrichtung (10) zur Änderung der Signalzustände,
**dadurch gekennzeichnet, dass**
- jedem in dem Speicher (1) gespeicherten Zeitgabewert (TCV) eine der Vielzahl der Signalflanken entsprechende Vielzahl von Speicherstellen zugeordnet ist, wobei
- in jeder Speicherstelle der Signalzustand eines Signals in binärer Form gespeichert ist, und wobei
- dem Vergleicher (4) eine Zeitversatzeinrichtung (3) vorgeschaltet ist, die zu dem aus dem Speicher (1) ausgelesenen Zeitgabewert (TCV) einen Zeitversatzwert addiert, wobei das Ergebnis der Addition dem Vergleicher (4) zugeführt wird.

2. Zeitgabevorrichtung nach Patentanspruch 1,
**dadurch gekennzeichnet, dass**
- der Zeitversatzwert als ein mit einer besonderen Codierung (ESB) versehenes Zeitgabeereignis in dem Speicher (1) abgelegt ist, der beim Auslesen aus dem Speicher (1) in ein Register der Zeitversatzeinrichtung (3) geladen wird.

3. Zeitgabevorrichtung nach Patentanspruch 1,
**dadurch gekennzeichnet, dass**
- der Zeitversatzwert in einem Register gespeichert ist, dessen Inhalt von einer Steuereinrichtung (6) gesteuert wird.

4. Zeitgabevorrichtung nach einem der vorhergehenden Patentansprüche,
**dadurch gekennzeichnet, dass**
- jedem Zeitgabeereignis ein Gruppencode (GEB) aus einer Vielzahl von Gruppencodes (GEB) zugeordnet ist.

5. Zeitgabevorrichtung nach Patentanspruch 4,
**dadurch gekennzeichnet, dass**
- eine Gruppenfreigabeeinrichtung (9) mit einem Gruppenfreigaberegister (12) vorgesehen ist, wobei die Gruppenfreigabeeinrichtung ein Gruppenfreigabesignal (GE) ausgibt, wenn ein Zeitgabeereignis mit einem bestimmten Gruppencode gemäß dem Eintrag in dem Gruppenfreigaberegister (12) gesperrt sein soll.

6. Zeitgabevorrichtung nach Patentanspruch 5,
**dadurch gekennzeichnet, dass**
- das Gruppenfreigaberegister (12) von einer Steuereinrichtung (6) gesteuert wird.

7. Zeitgabevorrichtung nach einem der vorhergehenden Patentansprüche,
**dadurch gekennzeichnet, dass**
- jedem Zeitgabeereignis ein Rahmencode (FEB) aus einer Vielzahl von Rahmencodes (FEB) geordnet ist.

8. Zeitgabevorrichtung nach Patentanspruch 7,
**dadurch gekennzeichnet, dass**
- eine Rahmenfreigabevorrichtung mit einem Rahmenzähler (13), einem Rahmenfreigaberegister (14) und einer Rahmenfreigabelogik (15) vorgesehen ist, wobei der Zählerstand des Rahmenzählers auf einen bestimmten Eintrag in dem Rahmenfreigaberegister (14) zeigt und dieser Eintrag in der Freigabelogik (15) mit dem momentanen Rahmencode (FEB) verarbeitet wird, um ein Rahmenfreigabesignal (FE) zu erzeugen.

9. Zeitgabevorrichtung nach Patentanspruch 8,
**dadurch gekennzeichnet, dass**
- das Rahmenfreigaberegister (12) von einer Steuereinrichtung (6) gesteuert wird.

10. Verfahren zum Erzeugen einer Vielzahl von Signalflanken zu vorbestimmbaren Zeitpunkten mit folgenden Schritten:
- Speichern einer Vielzahl von Zeitgabeereignissen (TE0, TE1, ...) in einer vorgegebenen Reihenfolge jeweils mit Zeitgabewerten (TCV) und einer Vielzahl von Signalzuständen (TRIG), indem jedem in dem Speicher (1) gespeicherten Zeitgabewert (TCV) eine der Vielzahl der Signalflanken entsprechende Vielzahl von Speicherstellen zugeordnet wird, wobei in jeder Speicherstelle der Signalzustand eines Signals in binärer Form gespeichert ist;
- Auslesen eines Zeitgabeereignisses aus dem Speicher (1);
- Vergleichen des im Zeitgabeereignis enthaltenen Zeitgabewertes (TCV) mit dem momentanen Zählerstand eines Zählers;
- Auslesen des nächsten Zeitgabeereignisses, wenn der gerade gelesene Zeitgabewert (TCV) mit dem momentanen Zählerstand des Zählers übereinstimmt;
- Ausgeben der Vielzahl von Signalzuständen (TRIG) eines Zeitgabeereignisses, wobei
- vor dem Schritt des Vergleichens ein Schritt des Addierens eines Zeitversatzwertes zum gerade ausgelesenen Zeitgabewert folgt.

11. Verwendung einer Vorrichtung nach einem der Patentansprüche 1 bis 9 in einem Mobilteil oder einer Basisstation eines Mobilfunksystems auf der Basis von TDMA.

## Claims

1. Timing apparatus for producing and emitting a large number of signal flanks by changing signal states at times which can be predetermined, having
- a cyclically addressed memory (1) in which a large number of timing events (TE0, TE1, ...) are stored, with each timing event having an associated timing value (TCV) which corresponds to a predetermined time,
- a comparator (4) which compares the instantaneous count of a counter (5) with the timing value of a timing event read at that instant from the memory (1), and which reads the next timing event from the memory (1) if they match, and
- an output device (10) for changing the signal states,
**characterized in that**
- each timing value (TCV) which is stored in the memory (1) is associated with a large number of memory locations corresponding to the large number of signal flanks, with
- the signal state of the signal being stored in binary form in each memory location, and with
- the comparator (4) being preceded by a time offset device (3) which adds a time offset value to the timing value (TCV) read from the memory (1), with the result of the addition being supplied to the comparator (4).

2. Timing apparatus according to Patent Claim 1,
**characterized in that**
- the time offset value is stored in the memory (1) as a timing event provided with a special coding (ESB) and is loaded, when read from the memory (1), into a register in the time offset device (3).

3. Timing apparatus according to Patent Claim 1,
**characterized in that**
- the time offset value is stored in a register whose contents are controlled by a control device (6).

4. Timing apparatus according to one of the preceding Patent Claims,
**characterized in that**
- each timing event is allocated a group code (GEB) from a large number of group codes (GEB).

5. Timing apparatus according to Patent Claim 4,
**characterized in that**
- a group enable device (9) having a group enable register (12) is provided, with the group enable device emitting a group enable signal (GE) when a timing event with a specific group code is intended to be inhibited on the basis of the entry in the group enable register (12).

6. Timing apparatus according to Patent Claim 5,
**characterized in that**
- the group enable register (12) is controlled by a control device (6).

7. Timing apparatus according to one of the preceding patent claims,
**characterized in that**
- each timing event is allocated a frame code (FEB) from a large number of frame codes (FEB).

8. Timing apparatus according to Patent Claim 7,
**characterized in that**
- a frame enable apparatus is provided, having a frame counter (13), a frame enable register (14) and frame enable logic (15), with the count of the frame counter pointing to a specific entry in the frame enable register (14), and this entry being processed in the enable logic (15) using the instantaneous frame code (FEB), in order to produce a frame enable signal (FE).

9. Timing apparatus according to Patent Claim 8,
**characterized in that**
- the frame enable register (12) is controlled by a control device (6).

10. Method for producing a large number of signal flanks at times which can be predetermined, comprising the following steps:
- storage of a large number of timing events (TE0, TE1, ...) in a predetermined sequence, in each case with timing values (TCV) and a large number of signal states (TRIG), in that each timing value (TCV) which is stored in the memory (1) is allocated one of the large number of memory locations which correspond to the large number of signal flanks, with the signal state of a signal being stored in binary form in each memory location;
- reading of a timing event from the memory (1);
- comparison of the timing value (TCV) contained in the timing event with the instantaneous count of a counter;
- reading of the next timing event when the timing value (TCV) that has just been read matches the instantaneous count of the counter;
- outputting of the large number of signal states (TRIG) for a timing event, with
- a step of addition of a time offset value to the timing value which has just been read being carried out before the comparison step.

11. Use of an apparatus according to one of Patent Claims 1 to 9 in a mobile part or in a mobile station in a mobile radio system based on TDMA.

## Revendications

1. Dispositif de synchronisation destiné à générer et délivrer une pluralité de fronts de signal en faisant varier des états de signal à des instants pouvant être prédéterminés, qui comporte
- une mémoire (1) adressée cycliquement dans laquelle est mémorisé une pluralité d'événements de synchronisation (TE0, TE1, ...), une valeur de synchronisation (TCV), qui correspond à un instant prédéterminé, étant associée à chaque événement de synchronisation,
- un comparateur (4) qui compare l'état instantané d'un compteur (5) à la valeur de synchronisation, lue instantanément dans la mémoire (1), d'un événement de synchronisation et qui, en cas de concordance, lit l'événement de synchronisation suivant dans la mémoire (1), et
- un dispositif de sortie (1) destiné à faire varier les états de signal,
**caractérisé en ce que**
- une pluralité de cellules de mémoires, correspondant au grand nombre de fronts de signal, est associée à chaque valeur de synchronisation (TCV) mémorisée dans la mémoire (1),
- l'état d'un signal est mémorisé sous forme binaire dans chaque emplacement de mémoire, et
- un dispositif de retard (3) est monté en amont du comparateur (4), lequel dispositif de retard ajoute à la valeur de synchronisation (TCV) lue dans la mémoire (1) une valeur de retard, le résultat de l'addition étant amené au comparateur (4).

2. Dispositif de synchronisation selon la revendication 1, **caractérisé en ce que** la valeur de retard est stockée sous forme d'événement de synchronisation, doté d'un code particulier (ESB), dans la mémoire (1), laquelle valeur de retard est chargée dans un registre du dispositif de retard (3) lors de la lecture de la mémoire (1).

3. Dispositif de synchronisation selon la revendication 1, **caractérisé en ce que** la valeur de synchronisation est mémorisée dans un registre dont le contenu est commandé par un dispositif de commande (6).

4. Dispositif de synchronisation selon l'une des revendications précédentes, **caractérisé en ce que** un code de groupe (GEB) issu d'une pluralité de codes de groupe (GEB) est associé à chaque événement de synchronisation.

5. Dispositif de synchronisation selon la revendication 4, **caractérisé en ce que** le registre de validation de groupe (12) est commandé par un dispositif de commande (6).

6. Dispositif de synchronisation selon la revendication 5, **caractérisé en ce que** le registre de validation de groupe (12) est commandé par un dispositif de commande (6).

7. Dispositif de synchronisation selon l'une quelconque des revendications précédentes, **caractérisé en ce qu'**un code de trame (FEB) issu d'une pluralité de codes de trame (FEB) est associé à chaque événement de synchronisation.

8. Dispositif de synchronisation selon la revendication 7, **caractérisé en ce qu'**il est prévu un dispositif de validation de trame comportant un compteur de trames (13), un registre de validation de trame (14) et une logique de validation de trame (15), l'état du compteur de trames indiquant une entrée déterminée dans le registre de validation de trame (14) et cette entrée étant traité dans la logique de validation (15) avec le code de trame instantané (FEB) afin de générer un signal de validation de trame (FE).

9. Dispositif de synchronisation selon la revendication 8, **caractérisé en ce que** le registre de validation de trame (12) est commandé par un dispositif de commande (6).

10. Procédé de synchronisation destiné à générer et délivrer une pluralité de fronts de signal à des instants prédéterminés, lequel procédé comporte les étapes suivantes consistant à
- mémoriser une pluralité d'événements de synchronisation (TE0, TE1, ...) dans un ordre prédéterminé à chaque fois avec des valeurs de synchronisation (TCV) et une pluralité d'états de signal (TRIG) en associant une pluralité d'emplacements mémoire, correspondant au grand nombre de fronts de signal, à chaque valeur de synchronisation stockées dans la mémoire (1), l'état de signal d'un signal étant mémorisé sous forme binaire à chaque emplacement de la mémoire,
- lire un événement de synchronisation dans la mémoire (1),
- comparer l'état instantané la valeur de synchronisation (TCV), contenue dans l'événement de synchronisation, à l'état instantané d'un compteur,
- lire l'événement de synchronisation instantané lorsque la valeur de synchronisation (TCV) qui vient d'être lue concorde avec l'état instantané du compteur,
- délivrer la pluralité d'états de signal (TRIG) d'un événement de synchronisation,
- réaliser avant l'étape de la comparaison une étape d'addition d'une valeur de retard à une valeur de synchronisation qui vient d'être lue.

11. Utilisation d'un dispositif selon l'une des revendications 1 à 9 dans une partie mobile ou une station de base d'un système de téléphone mobile fonctionnant en TDMA.
